# EUROPEAN PATENT APPLICATION

(11) **EP 4 358 681 A1**
(43) Date of publication of application: **24.04.2024**
(21) Application number: 23192794.8
(22) Date of filing: 22.08.2023
(51) Int. Cl.: H10K 59/80

(54) **DISPLAY DEVICE**

(30) Priority: 17.10.2022 KR 20220133549
(71) Applicant: Samsung Display Co., Ltd., Yongin-si, Gyeonggi-do 17113 (KR)
(72) Inventor: WOO, Junhyuk, 17113 Yongin-si (KR); KIM, Yong Seok, 17113 Yongin-si (KR); KIM, Youngchan, 17113 Yongin-si (KR); SON, Minhee, 17113 Yongin-si (KR); SHIN, Saet Byeol, 17113 Yongin-si (KR)
(74) Representative: Walaski, Jan Filip

(57) **Abstract**

A display device includes: a first substrate (SUB1) including emission areas (EA) and a peripheral area (PA) surrounding the emission areas (EA); a light emitting element layer (120) on the first substrate (SUB1) and overlapping the emission areas (EA); a plurality of light control patterns (LCP) overlapping the emission areas (EA) and the peripheral area (PA) and on the light emitting element layer (120); and a transmission pattern (TP) between the plurality of light control patterns (LCP) and having a refractive index of about 1.2 or more and less than about 1.5.

## Description

### BACKGROUND

### 1. FIELD

The disclosure relates to a display device.

### 2. DESCRIPTION OF THE RELATED ART

A display device is an electronic device that displays visual information to a user. Recently, as the thickness and weight of display devices decrease, the uses and applications of display devices have become more diversified.

A vehicle is currently one of the widely used means of transportation. Recently, vehicle display devices for displaying various functions to vehicles are being applied. The vehicle display devices may provide speed information, map information, and driving information to a driver or provide entertainment information to a passenger.

Meanwhile, at night, images displayed on a vehicle display device located in front of a driver or passenger may be reflected on a windshield. In this case, the image reflected on the windshield may interfere with the driver's driving. In addition, when an image viewed by the passenger through the vehicle display device is exposed to the driver, it may interfere with the driver's driving.

The above information disclosed in this Background section is only for enhancement of understanding of the background and therefore the information discussed in this Background section does not necessarily constitute prior art.

### SUMMARY

The disclosure relates to a display device. For example, the disclosure relates to a display device capable of adjusting a viewing angle.

Embodiments of the invention include a display device with relatively improved viewing angle adjusting performance.

A display device according to some embodiments may include a first substrate including emission areas and a peripheral area surrounding the emission areas, a light emitting element layer on the first substrate and overlapping the emission areas, a plurality of light control patterns overlapping the emission areas and the peripheral area and on the light emitting element layer and a transmission pattern between the plurality of light control patterns and having a refractive index of about 1.2 or more and less than about 1.5.

According to some embodiments, the display device may further include a planarization layer covering the plurality of the light control patterns and the transmission pattern.

According to some embodiments, the planarization layer may have the same refractive index as the transmission pattern.

According to some embodiments, the planarization layer may include the same material as the transmission pattern.

According to some embodiments, the planarization layer may include an organic matrix and inorganic particles dispersed in the organic matrix.

According to some embodiments, the display device may further include a second substrate overlapping the emission areas and the peripheral area and on the transmission pattern.

According to some embodiments, the second substrate may include glass.

According to some embodiments, the second substrate may have a greater refractive index than the transmission pattern.

According to some embodiments, the refractive index of the second substrate may be about 1.5.

According to some embodiments, the transmission pattern may include an organic matrix and inorganic particles dispersed in the organic matrix.

According to some embodiments, the organic matrix may include polysiloxane and the inorganic particles include silica clusters.

According to some embodiments, wherein the organic matrix may include acrylic resin and epoxy resin and the inorganic particles include hollow silica.

According to some embodiments, the plurality of the light control patterns may be arranged side by side in a plan view.

According to some embodiments, the plurality of the light control patterns may be arranged at equal interval from each other.

According to some embodiments, the plurality of the light control patterns may include molybdenum-tantalum oxide (MTO).

According to some embodiments, each of the plurality of light control patterns may have a multilayer structure and the multilayer structure may be at least one selected from the group consisting of MTO/Mo, MTO/Cu, MTO/Al, MTO/Mo/MTO, MTO/Cu/MTO, and MTO/Al/MTO.

According to some embodiments, the transmission pattern may include a first transmission pattern and a second transmission pattern alternately arranged with the first transmission pattern.

According to some embodiments, the first transmission pattern and the second transmission pattern may include the same material, and a height of the second transmission pattern may be greater than a height of the first transmission pattern.

According to some embodiments, the display device may further include an encapsulation layer between the light emitting element layer and the plurality of light control patterns and a touch sensing layer between the encapsulation layer and the plurality of light control patterns.

According to some embodiments, the display device may further include a color filter layer between the touch sensing layer and the plurality of light control patterns.

In a display device according to some embodiments of the present disclosure, a light control layer in a display device includes a transmission pattern and the planarization layer having a refractive index of about 1.2 or more and less than about 1.5, so that the path of the light passing through the light control layer may increase. Accordingly, the plurality of light control patterns included in the light control layer may absorb light more effectively. Also, due to this, the viewing angle of the display device may be relatively more effectively adjusted.

In addition, because the transmission pattern and the planarization layer included in the light control layer have a same refractive index, instances of a phenomenon in which images are separated due to a difference in refractive index may be prevented or reduced.

### BRIEF DESCRIPTION OF THE DRAWINGS

FIG. 1 is a side view illustrating a vehicle.
FIG. 2 is a view illustrating an interior space of the vehicle of FIG. **1****.**
FIG. 3 is a plan view illustrating a display device.
FIG. 4 is a cross-sectional view taken along the line I-I' of FIG. 3.
FIG. 5 is an enlarged cross-sectional view of the area A of FIG. 4.
FIG. 6 is an enlarged view of the area B of FIG. 5.
FIG. 7 is a view illustrating further details of the area B of FIG. 6.
FIG. 8 is a cross-sectional view illustrating further details of FIG. 4.
FIG. 9 is a cross-sectional view illustrating further details of FIG. 4.
FIG. 10 is a cross-sectional view illustrating further details of FIG. 9.

### DETAILED DESCRIPTION

Aspects of some embodiments of the present invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art. Like reference numerals refer to like elements throughout. As used herein, a reference number may indicate a singular element or a plurality of the element. For example, a reference number labeling a singular form of an element within the drawing figures may be used to reference a plurality of the singular element within the text of specification.

It will be understood that when an element is referred to as being related to another element such as being "on" another element, it can be directly on the other element or intervening elements may be present therebetween. In contrast, when an element is referred to as being related to another element such as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Aspects of some embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Illustrative, non-limiting embodiments will be more clearly understood from the following detailed description in conjunction with the accompanying drawings.

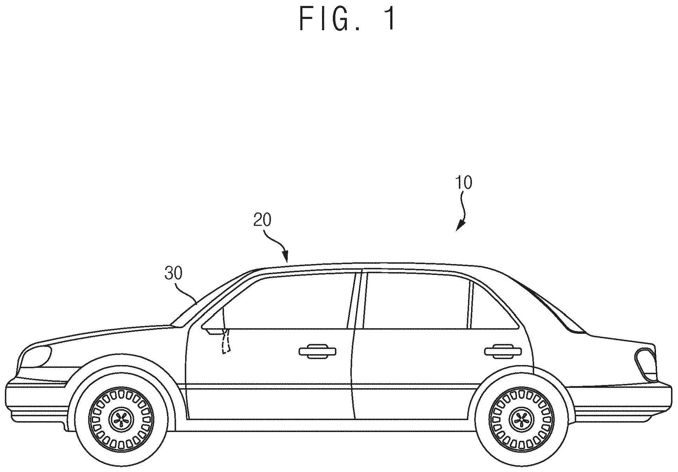

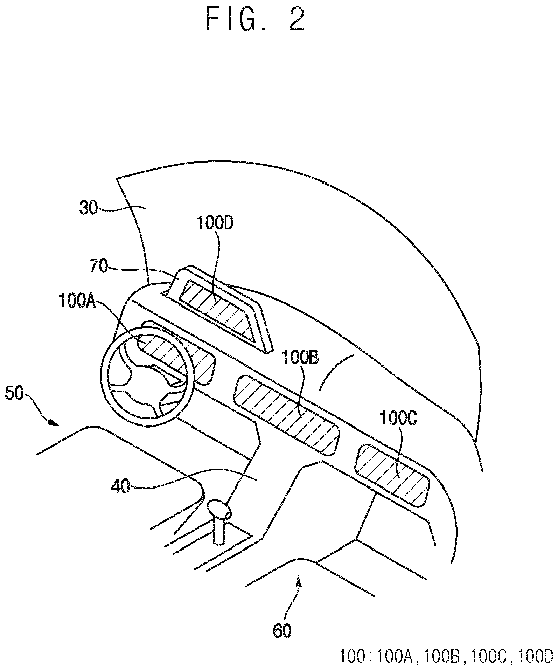

FIG. 1 is a side view illustrating a vehicle. FIG. 2 is a view illustrating an interior space of the vehicle of FIG. 1.

Referring to FIGS. 1 and 2, a vehicle 10 may include a vehicle body 20 and a vehicle display device 100. The vehicle body 20 forms the exterior of the vehicle 10 and defines an interior space in which a driver and passengers board and are seated therein. The vehicle body 20 includes a windshield 30 that protects the driver and the passengers from the outside and is clear to provide the driver with a view. The display device 100 may be located in the interior space.

The display device 100 may include a plurality of display devices 100A, 100B, and 100C, which may be located on a dashboard 40 provided in the indoor space. For example, the display device 100A may be located on the dashboard 40 in front of the driver's seat 50 to display speed information to the driver, and the display device 100B may be located on a center of the dashboard 40 to display map information and the like. In addition, the display device 100C may be located on the dashboard 40 in front of the passenger seat 60 to display entertainment information to a passenger.

Also, the display device 100D may be included in a vehicle heads-up display 70. The vehicle heads-up display 70 may be located on the dashboard 40. For example, the display device 100D may display information to the driver that may be helpful for driving.

The display device 100C located on the dashboard 40 may adjust a viewing angle according to a mode. The display device 100C may display images in a wide viewing angle mode or a narrow viewing angle mode. For example, the wide viewing angle mode refers to a state in which the viewing angle of the display device 100C is wide. In the wide viewing angle mode, an image may be displayed to the driver in the driver's seat 50 as well as the passenger in the passenger seat 60. Therefore, both the passenger and the driver may check the images displayed by the display device 100C. In contrast, the narrow viewing angle mode refers to a state in which the viewing angle of the display device 100C is narrow. In the narrow-view mode, images may be displayed only to a passenger in the passenger seat 60, and are not displayed to a driver in the driver's seat 50. Therefore, only the passenger may check the images of the display device 100C.

Although the display device 100C located on the dashboard 40 has been described as a reference, embodiments are not limited thereto and may be similarly applied to the display devices 100A, 100B, and 100D.

In addition, the display device 100 may also be located on the windshield 30.

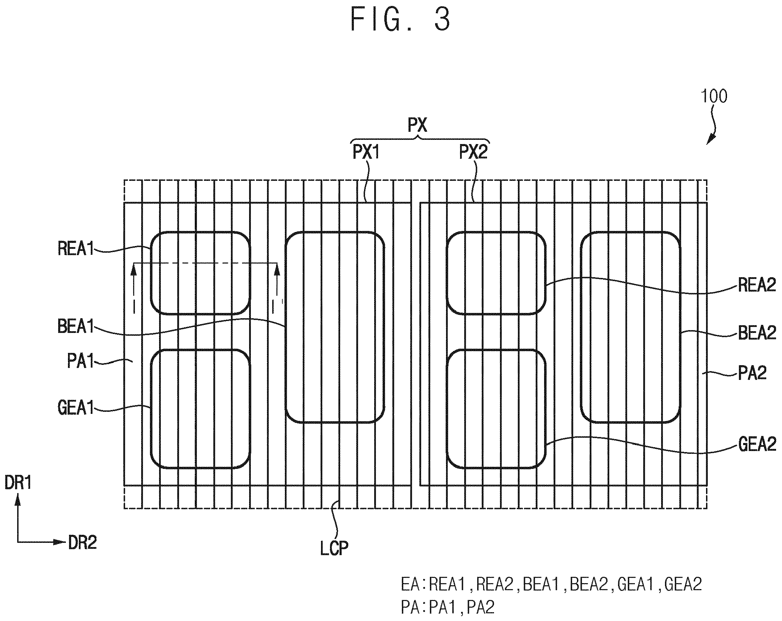

FIG. 3 is a plan view illustrating a display device.

Referring to FIG. 3, the display device 100 may include a display area and a non-display area. The display area is an area configured to display images. The non-display area may be arranged around the display area. The non-display area may surround the display area. The non-display area is an area that is not configured to display images. Drivers for displaying images in the display area may be located in the non-display area.

A plurality of pixels PX may be located in the display area. Signal lines such as a gate line and a data line may be located in the display area. The signal lines such as the gate line and the data line may be connected to each of the pixels. Each of the pixels may receive a gate signal, a data signal, and the like from the signal line.

The pixels PX located in the display area may include a first pixel PX1 and a second pixel PX2.

Each of the first pixel PX1 and the second pixel PX2 may include emission areas EA and a peripheral area PA. Light emitting elements may be respectively located in the emission areas EA, and light generated from the light emitting elements may be emitted from the emission areas EA. The peripheral area PA may surround the emission areas EA and may be an area in which the light emitting elements are not located.

For example, the first pixel PX1 may include a first red emission area REA1, a first green emission area GEA1, a first blue emission area BEA1, and a first peripheral area PA1. The first peripheral area PA may surround the first red emission area REA1, the first green emission area GEA1, and the first blue emission area BEA1. The second pixel PX2 may include a second red emission area REA2, a second green emission area GEA2, a second blue emission area BEA2, and a second peripheral area PA2. The second peripheral area PA may surround the second red emission area REA2, the second green emission area GEA2, and the second blue emission area BEA2.

The first red light emitting region REA1 and the second red light emitting region REA2 may emit red light. The first green emission area GEA1 and the second green emission area GEA2 may emit green light. The first blue emission area BEA1 and the second blue emission area BEA2 may emit blue light. The first peripheral area PA1 and the second peripheral area PA2 may not emit light. As the red light, the green light, and the blue light are combined, the first pixel PX1 and the second pixel PX2 may respectively emit light of various colors.

The display device 100 includes a plurality of light control patterns LCP. The plurality of light control patterns LCP overlap the emission areas EA and the peripheral area PA. The plurality of light control patterns LCP may be arranged side by side with each other in a plan view (e.g., a view normal or perpendicular with respect to the display surface). The plurality of light control patterns LCP may extend in the first direction DR1. The plurality of light control patterns LCP may be spaced apart from each other in a second direction DR2 crossing the first direction DR1. The plurality of light control patterns LCP may be parallel to each other. The plurality of light control patterns LCP may be arranged at substantially equal intervals from each other.

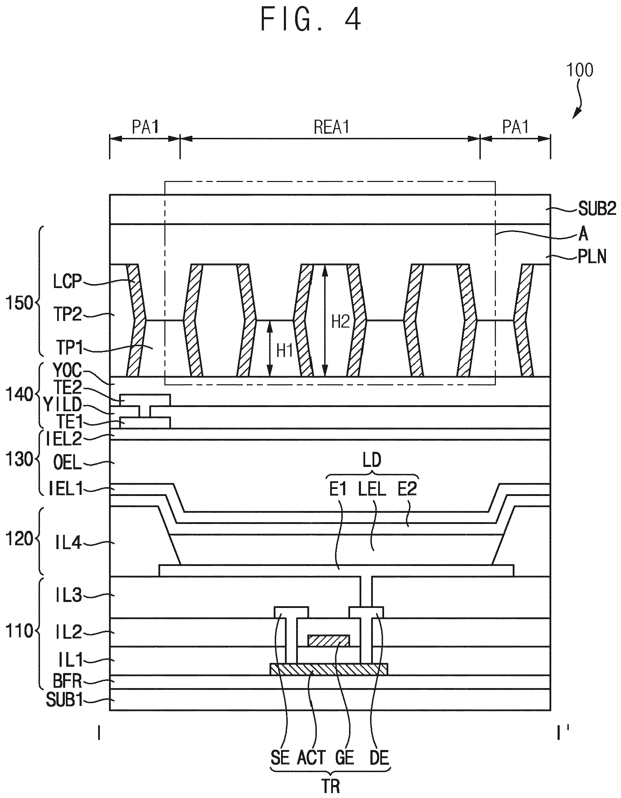

FIG. 4 is a cross-sectional view taken along the line I-I' of FIG. 3.

Referring to FIGS. 3 and 4, the display device 100 includes a first substrate SUB1 and may include a circuit element layer 110, a light emitting element layer 120, an encapsulation layer 130, a touch sensing layer 140, a light control layer 150, and a second substrate SUB2.

The first substrate SUB1 may include a transparent or opaque material. For example, the first substrate SUB1 may be a rigid substrate made of quartz, glass, or the like. As another example, the first substrate SUB1 may be a flexible substrate made of polyimide or the like. The flexible substrate may have a structure in which polyimide layers and barrier layers are alternately stacked.

The first substrate SUB1 includes the emission areas EA and the peripheral area PA as the display device 100 includes the emission areas EA and the peripheral area PA.

The circuit element layer 110 may be located on the first substrate SUB1, and include a buffer layer BFR, at least one transistor TR, a first insulating layer IL1, a second insulating layer IL2, and a third insulating layer IL3. The transistor TR may include an active layer ACT, a gate electrode GE, a source electrode SE, and a drain electrode DE. The light emitting element layer 120 may be located on the circuit element layer 110 and overlaps the emission areas EA. The light emitting element layer 120 may include a fourth insulating layer IL4 and light emitting diodes LD. Each of the light emitting diodes LD may include a first electrode E1, a light emitting layer LEL, and a second electrode E2.

The buffer layer BFR may be located on the first substrate SUB1. The buffer layer BFR may prevent or reduce diffusion of metal atoms, contaminants, or impurities from the first substrate SUB1 into the active layer ACT.

The active layer ACT may be located on the buffer layer BFR. The active layer ACT may be divided into a source region and a drain region doped with impurities and a channel region between the source region and the drain region.

The first insulating layer IL1 may be located on the buffer layer BFR. The first insulating layer IL1 may cover the active layer ACT and be formed to have substantially the same thickness along the profile of the active layer ACT. However, this is not limiting. For example, the first insulating layer IL1 may include an inorganic material.

The gate electrode GE may be located on the first insulating layer IL1. The gate electrode GE may overlap the channel region of the active layer ACT.

The second insulating layer IL2 may be located on the first insulating layer IL1. In addition, the second insulating layer IL2 may cover the gate electrode GE and be formed with substantially the same thickness along the profile of the gate electrode GE. However, this is not limiting.

The source electrode SE and the drain electrode DE may be located on the second insulating layer IL2. The source electrode SE may contact the source region of the active layer ACT through a first contact hole formed in the first and second insulating layers IL1 and IL2. The drain electrode DE may contact the drain region of the active layer ACT through a second contact hole formed in the first and second insulating layers IL1 and IL2.

The third insulating layer IL3 may be located on the second insulating layer IL2. In addition, the third insulating layer IL3 may cover the source and drain electrodes SE and DE, and have a substantially flat top surface without creating a step around the source and drain electrodes SE and DE. For example, the third insulating layer IL3 may include an organic material.

The light emitting diodes LD may be located on the third insulating layer IL3. The light emitting diodes LD may be respectively located in the emission areas EA.

The first electrode E1 may be located on the third insulating layer IL3. The first electrode E1 may have reflective or light-transmitting properties. For example, the first electrode E1 may include a metal and/or a light-transmitting conductive material.

The first electrode E1 may contact the source electrode SE or the drain electrode DE through a third contact hole formed in the third insulating layer IL3. Through this, the first electrode E1 may be connected to the transistor TR.

The fourth insulating layer IL4 may be located on the third insulating layer IL3, and an opening exposing an upper surface of the first electrode E1 may be defined in the fourth insulating layer IL4. there is. For example, the fourth insulating layer IL4 may include an organic material or an inorganic material.

A spacer may be located on the fourth insulating layer IL4. For example, the spacer may include an organic material or an inorganic material. The spacer may maintain a gap between the encapsulation layer 130 and the first substrate SUB1.

The light emitting layer LEL may be located on the first electrode E1. The light emitting layer LEL may be located in the opening formed in the fourth insulating layer IL4. The light emitting layer LEL may include organic and/or inorganic light emitting materials. The light emitting diode LD may have a multilayer structure including a hole injection layer, a hole transport layer, a light emitting layer, an electron transport layer, and an electron injection layer.

The second electrode E2 may cover the light emitting layer LEL and may be located on the fourth insulating layer IL4 and the spacer. The second electrode E2 may have a plate shape. In addition, the second electrode E2 may have light transmitting or reflecting properties. For example, the second electrode E2 may include a metal and/or a light-transmitting conductive material.

The encapsulation layer 130 may cover the light emitting diodes LD and may be located on the light emitting diodes LD. The encapsulation layer 130 may prevent or reduce penetration of contaminants, moisture, and oxygen into the light emitting diodes LD from the outside. For example, the encapsulation layer 130 may include a first inorganic encapsulation layer IEL1, an organic encapsulation layer OEL, and a second inorganic encapsulation layer IEL2.

The first inorganic encapsulation layer IEL1 may be located on the second electrode E2 with substantially the same thickness along the profile of the second electrode E2. The organic encapsulation layer OEL may be located on the first inorganic encapsulation layer IEL1, and may have a substantially flat upper surface without creating a step around the first inorganic encapsulation layer IEL1. The second inorganic encapsulation layer IEL2 may be located on the organic encapsulation layer OEL.

The touch sensing layer 140 may be located on the encapsulation layer 130. The touch sensing layer 140 may include a first touch electrode TE1, a touch insulating layer YILD, a second touch electrode TE2, and a touch planarization layer YOC.

The touch insulating layer YILD may be located on the first touch electrode TE1, and the second touch electrode TE2 may be located on the touch insulating layer YILD. The first touch electrode TE1 and the second touch electrode TE2 may be located in the peripheral area PA.

The touch planarization layer YOC may be located on the second touch electrode TE2. The touch planarization layer YOC may have a substantially flat upper surface. The touch planarization layer YOC may be substantially parallel to a upper surface of the light emitting diode LD. The second touch electrode TE2 may be connected to the first touch electrode TE1 through a contact hole. The touch sensing layer 140 may function as an input means of the display device 100.

The light control layer 150 may be located on the touch sensing layer 140. The light control layer 150 may include a transmission pattern TP, the plurality of light control patterns LCP, and a planarization layer PLN.

The transmission pattern TP may be located on the touch sensing layer 140. The transmission pattern TP may be located between the plurality of light control patterns LCP. The transmission pattern TP may include a first transmission pattern TP1 and a second transmission pattern TP2. The transmission pattern TP may include at least one of an acrylic resin, a methacrylic resin, a polyisoprene, a vinyl resin, an epoxy resin, a urethane resin, a cellulose resin, a siloxane resin, a polyimide resin, a polyamide resin, or a perylene resin.

The first transmission pattern TP1 and the second transmission pattern TP2 may be located adjacent to each other. For example, the first transmission pattern TP1 and the second transmission pattern TP2 may be alternately arranged. A height H₂ of the second transmission pattern TP2 may be greater than a height H1 of the first transmission pattern TP1.

The plurality of light control patterns LCP may be located on the touch sensing layer 140. The plurality of light control patterns LCP may cover side surfaces of the first transmission pattern TP1 and the second transmission pattern TP2.

The plurality of light control patterns LCP may include molybdenum-tantalum oxide (MTO). The plurality of light control patterns LCP may have a multilayer structure. For example, the plurality of light control patterns LCP may have an MTO single layer structure. For another example, the plurality of light control patterns LCP may have a double layer structure of at least one selected from the group consisting of MTO/Mo, MTO/Cu, and MTO/Al. For another example, the plurality of light control patterns LCP may have a triple layer structure of at least one selected from the group consisting of MTO/Mo/MTO, MTO/Cu/MTO, and MTO/Al/MTO. However, the plurality of light control patterns LCP is not limited to including molybdenum-tantalum oxide (MTO). For example, the plurality of light control patterns LCP may include various materials having relatively low transmittance and reflectance and relatively high absorbance.

Because light emitted from the light emitting diode LD passes between the plurality of light control patterns LCP, the viewing angle of the display device 100 may be adjusted. For example, a portion of the light having a relatively wide viewing angle may be absorbed by the plurality of light control patterns LCP in the narrow viewing angle mode. Also, in the narrow viewing angle mode, another portion of the light having a relatively narrow viewing angle may pass through the first transmission pattern TP1 or the second transmission pattern TP2 between the plurality of light control patterns LCP. Therefore, the viewing angle of the display device 100 may be adjusted through the plurality of light control patterns LCP.

Referring further to FIG. 1, the display device 100C in front of the passenger seat 60 may not be recognized or perceived by the driver through the plurality of light control patterns LCP. In this case, the plurality of light control patterns LCP may be arranged in a vertical direction.

In addition, the display devices 100A, 100B, and 100C located on the dashboard 40 are prevented from being reflected on the windshield 30 so that the driver's view may be secured. In this case, the plurality of light control patterns LCP may be located in the left and right directions. However, the disclosure is not limited thereto, and the plurality of light control patterns LCP may be arranged in up, down, left and right directions to have a grid pattern.

Referring back to FIGS. 3 and 4, the planarization layer PLN may be located on the plurality of light control patterns LCP and the transmission pattern TP. The planarization layer PLN may cover the plurality of light control patterns LCP and the transmission pattern TP, and have a substantially flat upper surface without creating a step around the plurality of light control patterns LCP and the transmission pattern TP.

The second substrate SUB2 may be located on the light control layer 150. The second substrate SUB2 may overlap the emission areas EA and the peripheral area PA. The second substrate SUB2 may include a transparent or opaque material. The second substrate SUB2 may include glass. For example, the second substrate SUB2 may be a rigid substrate made of quartz, glass, or the like.

A polarizer may be further located between the second substrate SUB2 and the light control layer 150. The polarizer may transmit light vibrating in a specific direction and absorb light vibrating in other directions. However, the polarizing plate may be omitted.

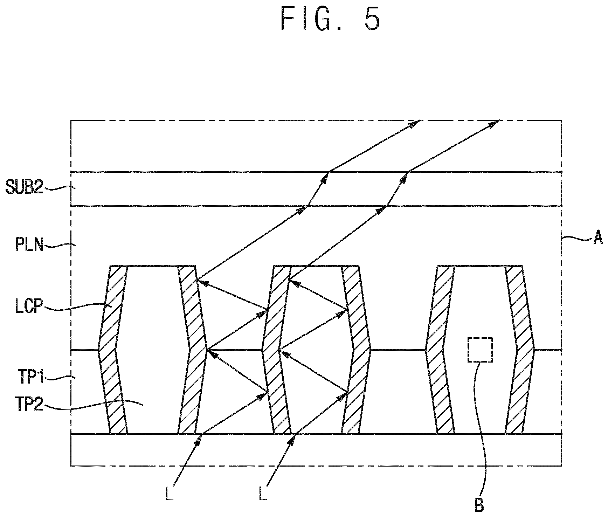

FIG. 5 is an enlarged cross-sectional view of area A of FIG. 4.

Referring to FIGS. 4 and 5, according to an embodiment of the invention, the transmission pattern TP has a refractive index of about 1.2 or more and less than about 1.5. For example, the first transmission pattern TP1 and the second transmission pattern TP2 may have the same refractive index. Each of the first transmission pattern TP1 and the second transmission pattern TP2 may have a refractive index of about 1.2 or more and less than about 1.5.

The planarization layer PLN may cover the plurality of light control patterns LCP and the transmission pattern TP, and may contact the transmission pattern TP. The planarization layer PLN may have the same refractive index as the transmission pattern TP. That is, the planarization layer PLN may have a refractive index of about 1.2 or more and less than about 1.5. The planarization layer PLN may include the same material as the transmission pattern TP.

The transmission pattern TP and the planarization layer PLN may have a refractive index less than a general organic layer. For example, the general organic layer may mean a layer including only an organic material without including additional particles. In this case, the general organic layer may have a refractive index of about 1.5. Because each of the transmission pattern TP and the planarization layer PLN has a refractive index of about 1.2 or more and less than about 1.5, the transmission pattern TP and the planarization layer PLN may have a refractive index less than the refractive index of the general organic layer. Therefore, because the transmission pattern TP and the planarization layer PLN have a relatively low refractive index, a path of the light L emitted from the light emitting diodes LD and incident on the light control layer 150 may be relatively long in the light control layer 150. For example, because the transmission pattern TP and the planarization layer PLN have a relatively low refractive index, the light L incident from the light emitting diodes LD to the light control layer 150 may be more refracted. Accordingly, the number of times the light L is reflected and re-incident to the plurality of light control patterns LCP may increase. That is, the path of the light L in the light control layer 150 may increase. Accordingly, the plurality of light control patterns LCP may more effectively absorb the light L, and the viewing angle of the display device 100 may be more effectively adjusted.

The second substrate SUB2 may have a greater refractive index than the transmission pattern TP. For example, the second substrate SUB2 may include glass, and the refractive index of the second substrate SUB2 may be about 1.5. The refractive index of air on the second substrate SUB2 may be about 1.0. Accordingly, the light L finally reflected by the plurality of light control patterns LCP may be incident to the second substrate SUB2 and may be refracted again by the second substrate SUB2. Also, the light L transmitted through the second substrate SUB2 may be refracted again.

According to some embodiments, the light control layer 150 included in the display device 100 includes the transmission pattern TP and the planarization layer PLN having a refractive index of about 1.2 or more and less than about 1.5, so that the path of the light L passing through the light control layer 150 may increase. Accordingly, the plurality of light control patterns LCP included in the light control layer 150 may absorb the light L more effectively. Also, because of this, the viewing angle of the display device 100 may be more effectively adjusted.

In addition, because the transmission pattern TP and the planarization layer PLN included in the light control layer 150 have the same refractive index, instances of a phenomenon in which images are separated due to a difference in refractive index may be prevented or reduced.

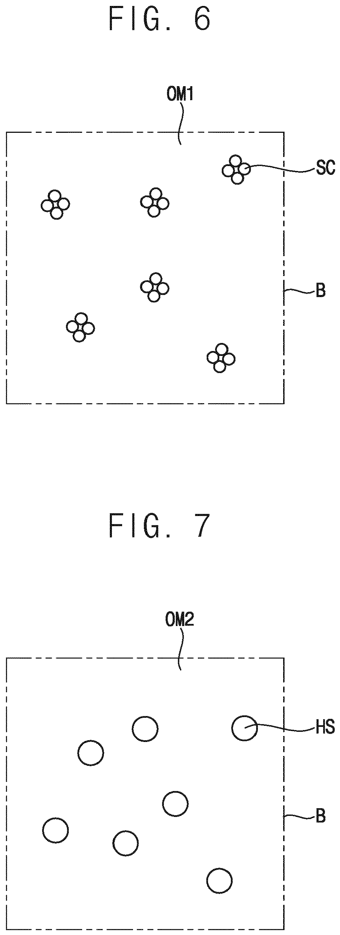

FIG. 6 is an enlarged view of area B of FIG. 5.

For example, FIG. 6 may be an enlarged view of an example of a material included in the transmission pattern TP of FIG. 5.

Further referring to FIG. 6, the transmission pattern TP may include an organic matrix OM and inorganic particles. The inorganic particles may be dispersed in the organic matrix OM.

The organic matrix OM may include polysiloxane. In this case, the refractive index of the organic matrix OM may be about 1.4. The inorganic particles may include silica clusters SC. The silica clusters SC may have a structure in which nano silica (SiO₂) is aggregated. The silica cluster SC may control the refractive index of the transmission pattern TP through an empty space between the nano silica particles. The refractive index of the silica cluster SC may be about 1.1. Each of the nano silica may have a diameter of about 15 nm or less.

When the transmission pattern TP includes the organic matrix OM and the inorganic particles, the transmission pattern TP may have a refractive index of about 1.22 to about 1.25. Accordingly, the path of the light L incident to the transmission pattern TP may increase.

The planarization layer PLN may include the same material as the transmission pattern TP. Accordingly, the planarization layer PLN may include the organic matrix OM and inorganic particles. The inorganic particles may be dispersed in the organic matrix OM. The organic matrix OM may include polysiloxane, and the inorganic particles may include silica clusters SC. Accordingly, the planarization layer PLN may have the same refractive index as the transmission pattern TP. However, the planarization layer PLN may include a material different from the transmission pattern TP.

FIG. 7 is a view illustrating another example of FIG. 6.

For example, FIG. 7 may be an enlarged view of another example of a material included in the transmission pattern TP of FIG. 5.

Referring to FIGS. 5 and 7, the transmission pattern TP may include an organic matrix OM' and inorganic particles. The inorganic particles may be dispersed in the organic matrix OM'.

The organic matrix OM' may include an acrylic resin and an epoxy resin. In this case, the refractive index of the organic matrix OM' may be about 1.6. The inorganic particles may include hollow silica HS. The hollow silica HS may have a hollow structure. Because the inside of the hollow silica HS is hollow, the refractive index of the transmission pattern TP may be controlled by controlling the content of the hollow silica HS. The refractive index of the hollow silica HS may be about 1.0. The hollow silica HS may have a diameter of about 60 nm or less.

When the transmission pattern TP includes the organic matrix OM' and the inorganic particles, the transmission pattern TP may have a refractive index of about 1.20 to about 1.24. Accordingly, the path of the light L incident to the transmission pattern TP may increase.

The planarization layer PLN may include the same material as the transmission pattern TP. Accordingly, the planarization layer PLN may include an organic matrix OM' and inorganic particles. The inorganic particles may be dispersed in the organic matrix OM'. The organic matrix OM' may include an acrylic resin and an epoxy resin, and the inorganic particles may include hollow silica HS. Accordingly, the planarization layer PLN may have the same refractive index as the transmission pattern TP. However, the planarization layer PLN may include a material different from the transmission pattern TP.

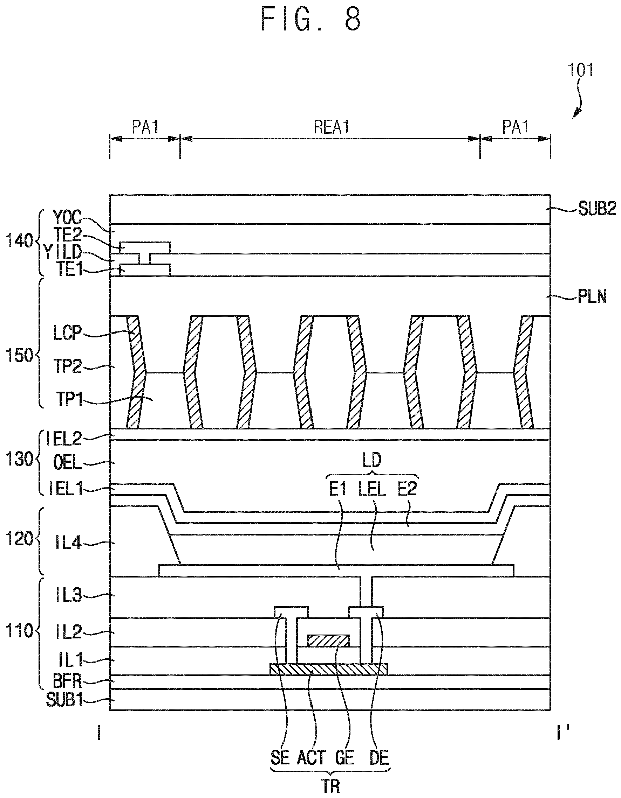

FIG. 8 is a cross-sectional view illustrating another example of FIG. 4.

A display device 101 of FIG. 8 may be the same as the display device 100 of FIG. 4 except for the stacking order. Therefore, redundant descriptions may be omitted.

Referring to FIG. 8, the light control layer 150 may be located between the encapsulation layer 130 and the touch sensing layer 140. For example, the circuit element layer 110 may be located on the first substrate SUB1, the light emitting element layer 120 may be located on the circuit element layer 110, and the encapsulation layer 130 may be located on the light emitting element layer 120. The light control layer 150 may be located on the encapsulation layer 130. The touch sensing layer 140 may be located on the light control layer 150, and the second substrate SUB2 may be located on the touch sensing layer 140.

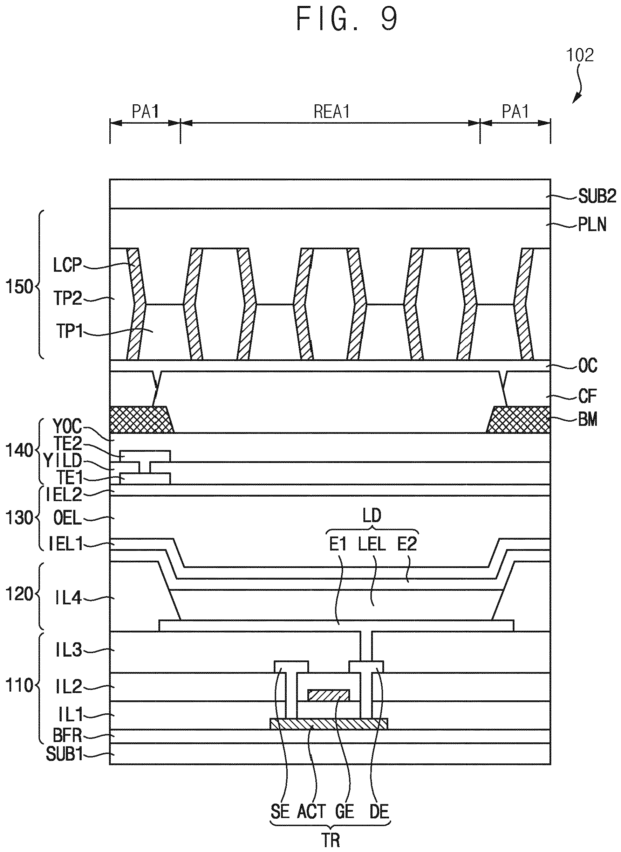

FIG. 9 is a cross-sectional view illustrating still another example of FIG. 4.

A display device 102 of FIG. 9 may be the same as the display device 100 of FIG. 4 except for a color filter layer CF, a black matrix BM, and an overcoat layer OC. Therefore, redundant descriptions may be omitted.

Referring to FIG. 9, a display device 102 may include a first substrate SUB1, a circuit element layer 110, a light emitting element layer 120, an encapsulation layer 130, a touch sensing layer 140, a light control layer 150, a second substrate SUB2, a color filter layer CF, a black matrix BM, and an overcoat layer OC.

The black matrix BM may be located on the touch planarization layer YOC. The black matrix BM may entirely overlap the peripheral area PA and may have a grid shape in the plan view. That is, the black matrix BM may overlap the sixth insulating layer IL6 and the touch electrode.

The black matrix BM may absorb external light. Accordingly, the black matrix BM may reduce an external light reflectance of the display device 101. The black matrix BM may include at least one of carbon black, black pigment, or black dye. These may be used alone or in combination with each other.

The black matrix BM may define a plurality of openings exposing a portion of the touch planarization layer YOC. For example, the black matrix BM may define an opening corresponding to the light emitting diode LD. That is, the opening may overlap the light emitting diode LD.

The color filter layer CF may be located between the touch sensing layer 140 and the light control layer 150. When the display device 101 includes the color filter layer CF, the polarizer may be omitted.

The color filter layer CF may be located in the opening defined by the black matrix BM. The color filter layer CF may partially overlap the black matrix BM. The color of light emitted from the light emitting diode LD may be more distinctly recognized as it passes through the color filter layer CF.

The color filter layer CF may transmit light of a specific color and block light of a color other than the specific color. For example, the color filter layer CF may include a dye and/or a pigment that absorbs light of a color other than the specific color.

The overcoat layer OC may be located on the black matrix BM and the color filter layer CF. The overcoat layer OC may cover the black matrix BM and the color filter layer CF. Accordingly, reliability of the black matrix BM and the color filter layer CF may be improved. The overcoat layer OC may have a substantially flat upper surface. Accordingly, the overcoat layer OC may compensate for a step difference on the lower surface. The overcoat layer OC may include an organic material. Examples of organic materials that can be used as the overcoat layer OC include photoresist, polyacrylic resin, polyimide resin, acrylic resin, epoxy resin, acrylate resin, and the like. These may be used alone or in combination with each other.

The light control layer 150 may be located on the overcoat layer OC. The light control layer 150 may include a transmission pattern TP, the plurality of light control patterns LCP, and a planarization layer PLN.

The transmission pattern TP may be located on the color filter layer CF and the overcoat layer OC. The transmission pattern TP may be located between the plurality of light control patterns LCP. The transmission pattern TP may include a first transmission pattern TP1 and a second transmission pattern TP2.

The plurality of light control patterns LCP may be located on the color filter layer CF and the overcoat layer OC. The plurality of light control patterns LCP may cover side surfaces of the first transmission pattern TP1 and the second transmission pattern TP2.

The plurality of light control patterns LCP may include molybdenum-tantalum oxide (MTO). The plurality of light control patterns LCP may have a multilayer structure. For example, the plurality of light control patterns LCP may have an MTO single layer structure. For another example, the plurality of light control patterns LCP may have a double layer structure of at least one selected from the group consisting of MTO/Mo, MTO/Cu, and MTO/Al. For another example, the plurality of light control patterns LCP may have a triple layer structure of at least one selected from the group consisting of MTO/Mo/MTO, MTO/Cu/MTO, and MTO/Al/MTO. However, the plurality of light control patterns LCP is not limited to including molybdenum-tantalum oxide (MTO). For example, the plurality of light control patterns LCP may include various materials having relatively low transmittance and reflectance and relatively high absorbance.

According to some embodiments, because light emitted from the light emitting diode LD passes between the plurality of light control patterns LCP, the viewing angle of the display device 100 may be adjusted. For example, portion of the light having a relatively wide viewing angle may be absorbed by the plurality of light control patterns LCP in the narrow viewing angle mode. Also, in the narrow viewing angle mode, another portion of the light having a relatively narrow viewing angle may pass through the first transmission pattern TP1 or the second transmission pattern TP2 between the plurality of light control patterns LCP. Therefore, the viewing angle of the display device 102 may be adjusted through the plurality of light control patterns LCP.

According to some embodiments, because the light control layer 150 included in the display device 102 includes the transmission pattern TP and the planarization layer PLN having a refractive index of about 1.2 or more and less than about 1.5, a path of the light L passing through the light control layer 150 may increase. Accordingly, the plurality of light control patterns LCP included in the light control layer 150 may absorb the light L more effectively. Also, because of this, the viewing angle of the display device 100 may be more effectively adjusted.

In addition, because the transmission pattern TP and the planarization layer PLN included in the light control layer 150 have the same refractive index, instances of a phenomenon in which images are separated due to a difference in refractive index may be prevented or reduced.

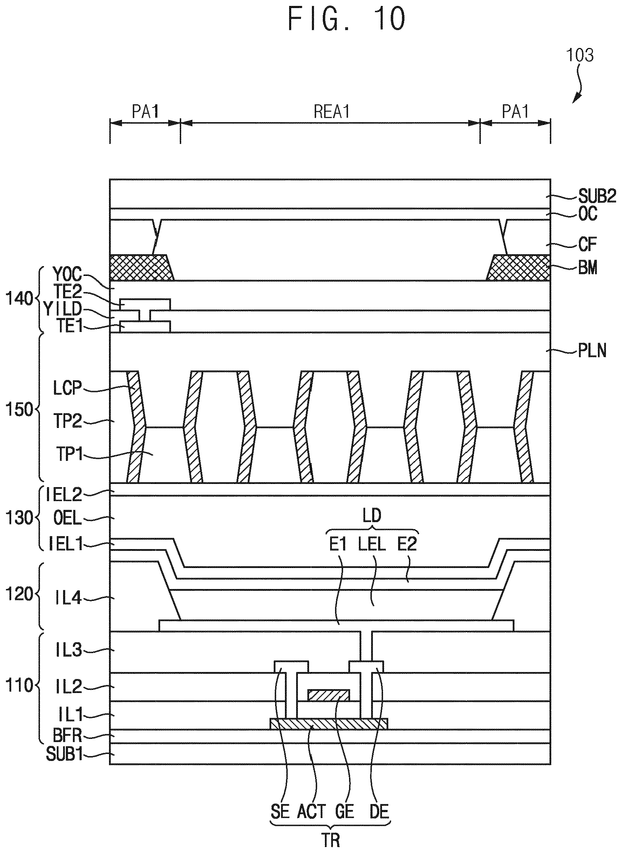

FIG. 10 is a cross-sectional view illustrating another example of FIG. 9.

A display device 103 of FIG. 10 may be the same as the display device 102 of FIG. 9 except for the stacking order. Therefore, redundant descriptions may be omitted.

Referring to FIG. 10, a light control layer 150 may be located between the encapsulation layer 130 and the touch sensing layer 140. For example, the circuit element layer 110 may be located on the first substrate SUB1, the light emitting element layer 120 may be located on the circuit element layer 110, and the encapsulation layer 130 may be located on the light emitting element layer 120. The light control layer 150 may be located on the encapsulation layer 130. The touch sensing layer 140 may be located on the light control layer 150, and the second substrate SUB2 may be located on the touch sensing layer 140.

The display devices may be applied to a display device included in a computer, a notebook, a mobile phone, a smartphone, a smart pad, a PMP, a PDA, an MP3 player, or the like.

Although aspects of the display devices according to some embodiments have been described with reference to the drawings, the illustrated embodiments are examples, and may be modified and changed by a person having ordinary knowledge in the relevant technical field without departing from the invention as defined by the claims.

## Claims

1. A display device comprising:
a first substrate (SUB1) including emission areas and a peripheral area surrounding the emission areas;
a light emitting element layer (120) on the first substrate and overlapping the emission areas;
a plurality of light control patterns (LCP) on the light emitting element layer, the plurality of light control patterns overlapping the emission areas and the peripheral area; and
a transmission pattern (TP) between the plurality of light control patterns and having a refractive index of about 1.2 or more and less than about 1.5.

2. The display device of claim 1, further comprising:
a planarization layer (PLN) covering the plurality of the light control patterns and the transmission pattern.

3. The display device of claim 2, wherein a refractive index of the planarization layer is equal to the refractive index of the transmission pattern.

4. The display device of claim 2 or 3, wherein the planarization layer includes the same material as the transmission pattern.

5. The display device of claim 2, 3 or 4, wherein the planarization layer includes an organic matrix and inorganic particles dispersed in the organic matrix.

6. The display device of any one of the preceding claims, further comprising:
a second substrate overlapping the emission areas and the peripheral area and on the transmission pattern.

7. The display device of claim 6, wherein a refractive index of the second substrate is greater than the refractive index of the transmission pattern.

8. The display device of claim 6 or 7, wherein a refractive index of the second substrate is 1.5.

9. The display device of any one of the preceding claims, wherein the transmission pattern includes an organic matrix and inorganic particles dispersed in the organic matrix.

10. The display device of claim 9, wherein the organic matrix includes polysiloxane and the inorganic particles include silica clusters.

11. The display device of claim 9, wherein the organic matrix includes acrylic resin and epoxy resin and the inorganic particles include hollow silica.

12. The display device of any one of the preceding claims, wherein the light control patterns are arranged side by side in a plan view.

13. The display device of any one of the preceding claims, wherein the plurality of the light control patterns are arranged at equal intervals.

14. The display device of any one of the preceding claims, wherein the plurality of the light control patterns include molybdenum-tantalum oxide (MTO).

15. The display device of claim 14, wherein each of the plurality of light control patterns has a multilayer structure and the multilayer structure is at least one selected from the group consisting of MTO/Mo, MTO/Cu, MTO/Al, MTO/Mo/MTO, MTO/Cu/MTO, and MTO/Al/MTO.
